# EUROPEAN PATENT APPLICATION

(11) **EP 4 700 316 A1**
(43) Date of publication of application: **25.02.2026**
(21) Application number: 24792597.7
(22) Date of filing: 12.04.2024
(51) Int. Cl.: F28D 15/02, C09K 5/04, F25B 1/00, F25B 39/02, F28D 15/06, H01L 23/427

(54) **COOLING SYSTEM**

(30) Priority: 18.04.2023 JP 2023068041
(71) Applicant: Shinwa Controls Co., Ltd., Kanagawa 215-0033 (JP)
(72) Inventor: SASAFUCHI, Tomoyoshi, Kawasaki-shi, Kanagawa 215-0033 (JP); KARIYA, Tomoyuki, Kawasaki-shi, Kanagawa 215-0033 (JP)
(74) Representative: Müller-Boré & Partner Patentanwälte PartG mbB
(86) International application number: PCT/JP2024/014760
(87) International publication number: WO 2024/219322

(57) **Abstract**

[Solving Means] A cooling system according to an embodiment includes: a refrigerant flow device (10) that includes a refrigerant flow path (11) through which a refrigerant flows and a control valve (14) that is provided in the refrigerant flow path (11) and controls flow of the refrigerant; and a pressure reducing device (20) that includes an introduction port (20A) and an outflow port (20B), the introduction port (20A) being connected to a downstream end (11D) of the refrigerant flow path (11) and sucking a gas from the refrigerant flow path (11), the outflow port (20B) being connected to an upstream end (11U) of the refrigerant flow path (11) and causing the gas sucked from the introduction port (20A) to flow into the refrigerant flow path (11) from the upstream end (11U) of the refrigerant flow path (11), the refrigerant flow path (11) allowing the refrigerant included in the gas flowed in from the pressure reducing device (20) to flow, the refrigerant flow device (10) including a temperature control unit (16) that cools a temperature control target by the refrigerant, on a downstream side of the control valve (14) in the refrigerant flow path (11).

## Description

### Technical Field

An embodiment of the present invention relates to a cooling system that utilizes a temperature drop of a refrigerant caused by reduction of pressure.

### Background Art

Vapor compression type refrigeration devices are widely used in many fields.

In the vapor compression type refrigeration device, a refrigerant is compressed by a compressor and the refrigerant flowing out from the compressor is cooled by a condenser. The refrigerant flowing out from the condenser is expanded by an expansion valve, and the refrigerant flowing out from the expansion valve exchanges heat with a temperature control target in an evaporator. The refrigerant absorbs heat from the temperature control target in the evaporator to cool it. The refrigerant flowing out from the evaporator circulates to the compressor and then releases heat in the condenser.

The refrigerant used in the vapor compression type refrigeration device is usually a fluorine based refrigerant. The fluorine refrigerant is a greenhouse gas and flammable in some cases, but has various advantages such as the ability to achieve highly-efficient operation.

Meanwhile, considering the environmental impact (greenhouse effect) of fluorine refrigerants, development of fluorine refrigerants for vapor compression type capable of keeping the global warming potential (GWP) low has been underway. Then, HFO refrigerants for vapor compression type with a very low GWP have already been put to practical use. Specifically, for example, an HFO refrigerant with a GWP of 10 or less has been put to practical use. However, this refrigerant is not necessarily sufficiently safe in terms of flammability and toxicity. For this reason, the development of refrigerants for vapor compression that have a low GWP and are capable of ensuring safety is still actively underway.

Further, the compressor used in the vapor compression type refrigeration device operates for a long period of time. For this reason, it is necessary to lubricate a driving portion such as a rotation portion with lubricating oil. However, the lubricating oil has a problem of flowing out to the refrigerant side. Then, the flowing out of lubricating oil causes the compressor to run out of oil in some cases, which impairs the stability of the operation of the compressor in some cases. Further, the cooling efficiency of the evaporator is impaired in some cases by the lubricating oil that has stagnated in the evaporator. For this reason, vapor compression type refrigeration devices leave room for various improvements also in terms of using a compressor.

Meanwhile, as cooling devices that do not use compressors, for example, boiling cooling devices disclosed in JP 2011-142298A, WO 2017/119113A, and JP 2021-162195A have been known.

The boiling cooling device is capable of efficiently cooling a temperature control target by absorbing heat due to latent heat by vaporizing a liquid when the liquid is caused to exchange heat with the temperature control target. Then, a pump is usually necessary to circulate the liquid or its vaporized gas, but the pump requires no lubricating oil or only a small amount of lubricating oil. Further, the energy consumption of the pump is relatively small. Therefore, it can be said that the boiling cooling device is a device with excellent environmental performance.

However, in the boiling cooling device, cooling at, for example, temperature ranges significantly below 0°C is generally not possible, so that the cooling temperature and the temperature control target are very limited. For this reason, it is difficult to achieve high refrigeration capacity at low or ultra-low temperature ranges using the boiling cooling device.

### Disclosure of Invention

In recent years, while the development of refrigerants with a small environmental impact, such as HFO refrigerants, has been underway as described above, development of antifreezes with a low environmental impact has also been underway. Then, an HFO solvent that has a low GWP, is non-flammable, and can be used as an antifreeze has been put to practical use. Such a solvent is not suitable for vapor compression type refrigeration devices because its boiling point under the atmospheric pressure is, for example, 70°C or higher. However, if a thermal cycle can be realized using such an HFO solvent, there is a possibility that a cooling system that is capable of ensuring a low environmental impact, high safety, and high refrigeration capacity, which are currently strongly desired, can be realized.

In this regard, the present inventors have conducted extensive research to realize a novel cooling system that is capable of using, for example, the above-mentioned HFO solvent as a refrigerant in a thermal cycle. More generally, they have conducted extensive research to realize a novel cooling system that is capable of shifting substances in a range different from the range of refrigerants that can be used in vapor compression type refrigeration devices to refrigerants that can be used in a thermal cycle. They have found that the above cooling system can be realized with a structure in which the temperature of the refrigerant is lowered by reducing the pressure, the temperature control target is cooled by the refrigerant, and then the heat absorbed by the refrigerant is released under the atmospheric pressure, leading to the present invention.

That is, an object of the present invention is to provide a cooling system that allows a substance that has not been used in existing refrigeration methods to be used as a refrigerant in a thermal cycle or allows the range of substances that can be used as a refrigerant in a thermal cycle to be expanded.

An embodiment of the present invention relates to the following aspects "1" to "10".
[1] A cooling system, comprising:
   a refrigerant flow device that includes a refrigerant flow path through which a refrigerant flows and a control valve that is provided in the refrigerant flow path and controls flow of the refrigerant; and
   a pressure reducing device that includes an introduction port and an outflow port, the introduction port being connected to a downstream end of the refrigerant flow path and sucking a gas from the refrigerant flow path, the outflow port being connected to an upstream end of the refrigerant flow path and causing the gas sucked from the introduction port to flow into the refrigerant flow path from the upstream end of the refrigerant flow path,
   the refrigerant flow path allowing the refrigerant included in the gas flowed in from the pressure reducing device to flow,
   the refrigerant flow device including a temperature control unit that cools a temperature control target by the refrigerant, on a downstream side of the control valve in the refrigerant flow path.
[2] The cooling system according to [1], in which
   the refrigerant flow device includes, on a downstream side of temperature control unit in the refrigerant flow path, a gas-liquid separator that separates a gas phase portion and a liquid phase portion of the refrigerant that has passed through the temperature control unit such that the gas phase portion flows downstream of the liquid phase portion.
[3] The cooling system according to [1] or [2], in which
   the refrigerant flow device includes, on an upstream side of the control valve in the refrigerant flow path, a reservoir tank that stores the refrigerant that has changed to a liquid phase from the gas flowed into the refrigerant flow path from the pressure reducing device, and
   the control valve controls flow of the refrigerant in the liquid phase flowed in from the reservoir tank.
[4] The cooling system according to [3], in which
   the reservoir tank includes a cooler that cools the gas flowed in from the pressure reducing device and liquefies the refrigerant from the gas.
[5] The cooling system according to any one of [1] to [4], in which
   the refrigerant flow device includes a two-layer flow separator between the control valve and the temperature control unit in the refrigerant flow path, and
   the two-layer flow separator includes an inlet that causes the refrigerant from the control valve to flow in and an outlet that is provided below the inlet and causes the refrigerant flowed in from the inlet to flow out.
[6] The cooling system according to any one of [1] to [5], in which
   a portion of the refrigerant flow path between the control valve and the temperature control unit and a portion of the refrigerant flow path on a downstream side of the temperature control unit constitute an internal heat exchanger that allows the refrigerants flowing through the portions to exchange heat with each other.
[7] The cooling system according to any one of [1] to [6], in which
   the cooling system is configured to form a state in which a pressure inside a portion of the refrigerant flow path on a downstream side of the control valve is lower than a pressure inside a portion of the refrigerant flow path on an upstream side of the control valve by an operation of the pressure reducing device and a throttle state of the control valve.
[8] The cooling system according to any one of [1] to [7], in which
   the refrigerant is a substance whose boiling point is 30°C or more under an atmospheric pressure.
[9] The cooling system according to any one of [1] to [8], in which
   the refrigerant has a GWP of 10 or less.
[10] The cooling system according to any one of [1] to [9], in which
   the refrigerant is HFO-1336mzz-Z.

According to the present invention, it is possible to allow a substance that has not been used in existing refrigeration methods to be used as a refrigerant in a thermal cycle or allow the range of substances that can be used as a refrigerant in a thermal cycle to be expanded.

### Brief Description of Drawings

[Fig. 1] Fig. 1 is a diagram schematically showing a cooling system according to an embodiment.
[Fig. 2] Fig. 2 is a block diagram showing a functional configuration of a controller constituting the cooling system in Fig. 1.
[Fig. 3] Fig. 3 is a pressure-enthalpy chart of an example of a refrigerant used in the cooling system in Fig. 1.
[Fig. 4] Fig. 4 is a schematic diagram of a plasma etching apparatus that includes the cooling system shown in Fig. 1, which is an application example of the cooling system.
[Fig. 5] Fig. 5 is a schematic diagram of cooking equipment that includes the cooling system shown in Fig. 1, which is an application example of the cooling system.
[Fig. 6] Fig. 6 is a schematic diagram of a molding apparatus that includes the cooling system shown in Fig. 1, which is an application example of the cooling system.
[Fig. 7] Fig. 7 is a schematic diagram of a freezer/refrigerator warehouse that includes the cooling system shown in Fig. 1, which is an application example of the cooling system.
[Fig. 8] Fig. 8 is a diagram schematically showing a cooling system according to a modified example.

### Mode(s) for Carrying Out the Invention

An embodiment will be described below.

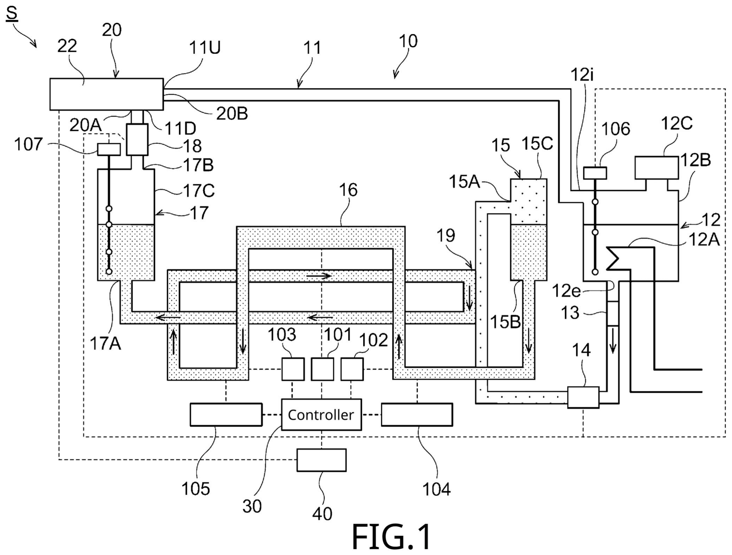

Fig. 1 is a schematic diagram showing a cooling system S according to an embodiment. First, a configuration of the cooling system S will be described.

### (Configuration of cooling system)

As shown in Fig. 1, the cooling system S includes a refrigerant flow device 10, a pressure reducing device 20, and a controller 30.

The refrigerant flow device 10 includes a refrigerant flow path 11 through which a refrigerant flows. The refrigerant flow path 11 includes an upstream end 11U and a downstream end 11D. The pressure reducing device 20 includes an introduction port 20A and an outflow port 20B, the introduction port 20A being connected to the downstream end 11D of the refrigerant flow path 11 and sucking a gas from the refrigerant flow path 11, the outflow port 20B being connected to the upstream end 11U of the refrigerant flow path 11 and causing the gas sucked from the introduction port 20A to flow into the refrigerant flow path 11 from the upstream end 11U.

The refrigerant flow device 10 includes a reservoir tank 12, a dryer 13, a control valve 14, a two-layer flow separator 15, a temperature control unit 16, a gas-liquid separator 17, and a butterfly valve 18, which are provided in the refrigerant flow path 11, in this order from the upstream side to the downstream side. That is, the refrigerant flow path 11 is configured by connecting the reservoir tank 12, the dryer 13, the control valve 14, the two-layer flow separator 15, the temperature control unit 16, the gas-liquid separator 17, and the butterfly valve 18 in this order using piping members.

During the operation of the cooling system S, the control valve 14 in the refrigerant flow path 11 is controlled to be in a state in which the degree of opening is narrowed. In this state, the pressure reducing device 20 sucks, from the downstream end 11D of the refrigerant flow path 11, the gas present in the refrigerant flow path 11 or the gas vaporized in the refrigerant flow path 11. In this way, the pressure reducing device 20 reduces the pressure inside the portion of the refrigerant flow path 11 downstream of the control valve 14 or maintains the reduced pressure.

As described above, when the pressure reducing device 20 sucks the gas from the refrigerant flow path 11, the pressure inside the portion of the refrigerant flow path 11 downstream of the control valve 14 is reduced to a pressure lower than the atmospheric pressure. Meanwhile, the pressure inside the portion of the refrigerant flow path 11 upstream of the control valve 14 is set to a pressure higher than the pressure inside the portion of the refrigerant flow path 11 downstream of the control valve 14, e.g., the atmospheric pressure.

The gas sucked by the pressure reducing device 20 from the downstream end 11D of the refrigerant flow path 11 flows into the inside of the refrigerant flow path 11 from the upstream end 11U of the refrigerant flow path 11. The refrigerant flow device 10 causes the refrigerant included in the gas flowed in from the pressure reducing device 20 to flow through the refrigerant flow path 11. Then, the refrigerant flow device 10 liquefies the refrigerant as much as possible before the refrigerant reaches the control valve 14 in the refrigerant flow path 11. Then, the liquefied refrigerant is depressurized and reduces its temperature when flowing into the portion of the refrigerant flow path 11 downstream of the control valve 14. In this way, the temperature control unit 16 located in the refrigerant flow path 11 downstream of the control valve 14 allows a low-temperature refrigerant to flow. Then, the refrigerant and the temperature control target exchange heat in the temperature control unit 16, thereby allowing the temperature control target to be cooled by the refrigerant.

In the temperature control unit 16, the refrigerant that exchanges heat with the temperature control target can evaporate by absorbing heat from the temperature control target. In this case, the refrigerant is capable of efficiently cooling the temperature control target by latent heat of vaporization. Then, the above evaporated refrigerant is in a gaseous state and sucked by the pressure reducing device 20. Here, the refrigerant in the gas phase sucked by the pressure reducing device 20 has absorbed heat from the temperature control target. This heat absorbed by the refrigerant is released to the outside mainly in the reservoir tank 12 in the refrigerant flow path 11 in this embodiment. This allows the temperature control target to be continuously cooled.

The refrigerant to be circulated by the cooling system S is not particularly limited, but is, for example, a substance that becomes liquid under the atmospheric pressure and at a standard environmental temperature (e.g., 25°C), which becomes -5°C or lower when expanded in an environment of, for example, 0.1 atm, desirably a substance that becomes -30°C or lower when expanded in an environment of 0.01 atm. In the case of using such a substance as a refrigerant, cooling to a low-temperature range is possible. Note that in the present specification, the atmospheric pressure means 1 atm, in other words, 0.1 MPa (Abs).

The refrigerant flow device 10 and the pressure reducing device 20 constituting the cooling system S will be described below in detail.

The reservoir tank 12 in the refrigerant flow device 10 stores the refrigerant that has changed to a liquid phase from the gas flowed into the refrigerant flow path 11 from the pressure reducing device 20. As described above, the pressure inside the portion of the refrigerant flow path 11 upstream of the control valve 14 is higher than the pressure inside the portion of the refrigerant flow path 11 downstream of the control valve 14. For this reason, the gas flowed into the refrigerant flow path 11 from the pressure reducing device 20 is pressurized and heated up. At this time, the refrigerant contained in the gas is also pressurized from the gas phase state, heated up, and then attempts to liquefy.

The refrigerant contained in the gas flowed in from the pressure reducing device 20 can be at least partially a liquid phase before reaching the reservoir tank 12. The reservoir tank 12 is capable of storing the refrigerant that has changed to a liquid phase naturally in this way. However, it is difficult to liquefy all of the refrigerant in the gas phase flowing in from the pressure reducing device 20 before reaching the reservoir tank 12 in some cases. In this regard, the reservoir tank 12 according to this embodiment includes a cooler 12A that cools and liquefies the refrigerant in the gas phase. The cooler 12A is provided in the reservoir tank 12 and cools mainly the gas flowed into the reservoir tank 12 from the pressure reducing device 20. This allows most of the refrigerant in the gas flowed in from the pressure reducing device 20 to be liquefied in the reservoir tank 12 and the refrigerant in the liquid phase to be stored. Note that the cooler 12A may be provided outside the reservoir tank 12 and may be configured to cool the portion of the refrigerant flow path 11 on the upstream side of the reservoir tank 12, for example.

The reservoir tank 12 includes a gas inlet 12i on the upper part thereof and an output port 12e on the bottom portion thereof, the output port 12e causing the refrigerant in the liquid phase to flow out to the downstream side. In detail, the reservoir tank 12 includes a container body 12B having an opening and a lid 12C for opening and closing the opening. The inlet 12i is provided on the upper part of the container body 12B, and the output port 12e is provided on the bottom portion of the container body 12B. However, the positions of the inlet 12i and the output port 12e are not particularly limited. Further, in the reservoir tank 12, by opening the lid 12C, for example, it is possible to avoid an increase in pressure in the reservoir tank 12 and suppress power consumption of the pressure reducing device 20. Further, by opening the lid 12C, it is possible to supply or replenish the refrigerant.

The dryer 13 adsorbs moisture and foreign substances contained in the refrigerant in the liquid phase from the reservoir tank 12. The dryer 13 may be configured by housing a porous material in a canister (container portion). In this case, the porous material may be a molecular sieve, activated alumina, a mixture thereof, or the like.

The control valve 14 controls the flow of the refrigerant flowed in from the dryer 13. In detail, the control valve 14 controls the flow of the refrigerant mainly in the liquid phase flowed in from the dryer 13. During the operation of the cooling system S, the degree of opening of the control valve 14 is narrowed to control the flow of the refrigerant as the sucking operation of the pressure reducing device 20 starts, thereby controlling the inside of the portion of the refrigerant flow path 11 downstream of the control valve 14 to a desired reduced pressure state. Further, the control valve 14 is capable of adjusting, for example, the temperature of the refrigerant flowing through the temperature control unit 16 or the cooling capacity by adjusting the flow rate of the refrigerant flowing out from the control valve 14 to the downstream side.

Further, as described above, the pressure inside the portion of the refrigerant flow path 11 upstream of the control valve 14 is higher than the pressure inside the portion of the refrigerant flow path 11 downstream of the control valve 14. For this reason, the refrigerant passing through the control valve 14 is depressurized and cooled down when flowing into the portion of the refrigerant flow path 11 downstream of the control valve 14. In other words, the refrigerant passing through the control valve 14 is expanded when flowing into the portion of the refrigerant flow path 11 downstream of the control valve 14 and is cooled down. Therefore, the control valve 14 also functions like an expansion valve in a refrigeration circuit, which expands the refrigerant in the liquid phase.

The refrigerant flowing out from the control valve 14 can partially vaporize due to expansion. Therefore, the refrigerant flowing out from the control valve 14 flows to the downstream side in the state of a gas-liquid mixed phase in some cases. However, the refrigerant flowing out from the control valve 14 remains in the liquid phase and flows downstream in some cases. In either case, the refrigerant is depressurized (expanded), so its temperature decreases. The type of control valve 14 is not particularly limited, but is an electric proportional control valve in this embodiment. The control valve 14 is electrically connected to the controller 30. The control valve 14 is controlled by the controller 30.

The two-layer flow separator 15 includes an inlet 15A and an outlet 15B, the inlet 15A causing the refrigerant from the control valve 14 to flow in, the outlet 15B being provided below the inlet 15A and causing the refrigerant flowed in from the inlet 15A to flow out. In the portion of the refrigerant flow path 11 on the downstream side of the control valve 14, basically, the temperature of the refrigerant located in the region on the downstream side is lower than the temperature of the refrigerant located in the region on the upstream side. Then, the temperature of the refrigerant immediately after flowing out from the control valve 14 is normally higher than the temperature of the refrigerant already present in the region on the downstream side thereof. Further, the refrigerant immediately after flowing out from the control valve 14 flows rapidly toward the downstream side. In this regard, the two-layer flow separator 15 is provided to prevent the high-temperature phase of the refrigerant flowing out from the control valve 14 from rapidly flowing out to the downstream side.

That is, in the two-layer flow separator 15, the inlet 15A is provided above the outlet 15B, so that the high-temperature phase of the refrigerant is less likely to flow straight toward the outlet 15B. Further, the high-temperature phase of the refrigerant tends to flow relatively upward as compared with the lower-temperature phase and thus is less likely to flow straight toward the outlet 15B. The two-layer flow separator 15 prevents the high-temperature phase of the refrigerant flowed into the two-layer flow separator 15 from flowing straight toward the outlet 15B as described above, thereby preventing the high-temperature phase from rapidly flowing out to the downstream side.

In detail, the two-layer flow separator 15 includes a container body 15C that defines the internal space such that it forms a flow path cross-sectional area larger than the flow path cross-sectional area of the piping member connecting the inlet 15A and the control valve 14. The inlet 15A is provided on the upper part of the side wall of the container body 15C (portion of the side wall on the upper side of the center in the up-and-down direction), and the outlet 15B is provided on the bottom wall of the container body 15C. Then, in this embodiment, the inlet 15A and the outlet 15B do not overlap with each other in the horizontal direction. Then, the inlet 15A and the outlet 15B are relatively away from each other in the up-and-down direction. In such a configuration, the high-temperature phase of the refrigerant flowing out from the control valve 14 is less likely to reach the outlet 15B. However, the formation positions of the inlet 15A and the outlet 15B are not particularly limited. Note that the state in which the inlet 15A and the outlet 15B do not overlap with each other in the horizontal direction means that when the inlet 15A is projected toward the outlet 15B in the horizontal direction, they do not overlap with each other at all. However, the formation positions of the inlet 15A and the outlet 15B are not limited to this aspect.

In Fig. 1, the inside of the two-layer flow separator 15 is depicted as being color-coded. This indicates that the portion of the refrigerant represented in a darker color (lower part in the figure) is at a lower temperature than the portion of the refrigerant represented in a lighter color than the darker color (upper part in the figure).

The temperature control unit 16 causes the refrigerant flowing out from the two-layer flow separator 15 to flow and cools a temperature control target (not shown) by this refrigerant. The temperature control unit 16 may be formed in, for example, a meandering shape, a spiral shape, or a curved shape. The configuration of the temperature control unit 16 is not particularly limited. The temperature control unit 16 may be configured by, for example, a fin-tube type heat exchanger or may include a plate-shaped heat transfer material.

The gas-liquid separator 17 causes the refrigerant that has passed through the temperature control unit 16 to flow in and separates the refrigerant into a gas phase portion and a liquid phase portion. In detail, the gas-liquid separator 17 separates the gas phase portion and the liquid phase portion such that the gas phase portion of the refrigerant that has passed through the temperature control unit 16 flows downstream of the liquid phase portion. In the case where the temperature control unit 16 causes the refrigerant to exchange heat with the temperature control target, part of the refrigerant can evaporate and vaporize. For this reason, the refrigerant flowing from the temperature control unit 16 to the gas-liquid separator 17 can include the gas phase portion and the liquid phase portion. The gas-liquid separator 17 functions to separate the refrigerant in the gas phase and the refrigerant in the liquid phase, of the refrigerant that has passed through the temperature control unit 16, and cause the refrigerant in the gas phase to flow toward the upper side.

The gas-liquid separator 17 includes an inlet 17A and an outlet 17B, the inlet 17A causing the refrigerant from the temperature control unit 16 to flow in, the outlet 17B being provided above the inlet 17A and causing the refrigerant flowed in from the inlet 17A to flow out. In detail, the gas-liquid separator 17 includes a container body 17C that defines the internal space such that it forms a flow path cross-sectional area larger than the flow path cross-sectional area of the piping member connecting the inlet 17A and the temperature control unit 16. The inlet 17A is provided on the bottom wall of the container body 17C, and the outlet 17B is provided on the top wall of the container body 17C. The positions of the inlet 17A and the outlet 17B are not particularly limited, but the inlet 17A and the outlet 17B are favorably far away from each other in the up-and-down direction. In this case, the gas phase tends to flow upward relative to the liquid phase, so that the above gas phase portion in the refrigerant flowed to the downstream side in the gas-liquid separator 17 is more easily output to the downstream side from the outlet 17B. Further, the refrigerant in the liquid phase is prevented from being sucked by the pressure reducing device 20.

The portion in the gas-liquid separator 17 represented in a darker color indicates the liquid phase portion and the portion thereabove indicates the gas phase portion. In the gas-liquid separator 17, it is favorable to introduce the refrigerant in the liquid phase into the gas-liquid separator 17 such that a gas phase is constantly formed on the upper part. The environment in which the refrigerant in the liquid phase and the gas phase portion coexist in the gas-liquid separator 17 can be formed by controlling the operations of the pressure reducing device 20, the control valve 14, and the like. The gas-liquid separator 17 may be configured to have a structure capable of maintaining its shape when the internal pressure is reduced, and may include a so-called vacuum insulated container. The maintenance of the shape of the gas-liquid separator 17 during reduction of pressure depends on the internal pressure to be reduced, but the outer shell portion of the gas-liquid separator 17 is favorably formed of a hard metal having a large thickness in the case where the pressure is reduced to 0.1 atm, for example. However, the specific structure of the gas-liquid separator 17 should be determined as appropriate in accordance with the expected degree of reduction of pressure and is not particularly limited.

Further, in this embodiment, the gas-liquid separator 17 and the reservoir tank 12 are located at the same or substantially the same position in the up-and-down direction. As a result, in this embodiment, while the operation is stopped, the refrigerant flows such that the liquid level height of the refrigerant in the liquid phase in the gas-liquid separator 17 and the liquid level height of the refrigerant in the liquid phase in the reservoir tank 12 are the same. By forming such a state, the next operation can be started smoothly.

The butterfly valve 18 is a valve that controls the amount of gas in the refrigerant flow path 11 sucked by the pressure reducing device 20. The butterfly valve 18 may be configured to control the degree of opening by an electric motor, for example. The butterfly valve 18 is electrically connected to the controller 30. The butterfly valve 18 is controlled by the controller 30.

Further, in this embodiment, the portion of the refrigerant flow path 11 between the control valve 14 and the temperature control unit 16 and the portion of the refrigerant flow path 11 on the downstream side of the temperature control unit 16 constitute an internal heat exchanger 19 that allows the refrigerants flowing through the portions to exchange heat with each other. The portion of the refrigerant flow path 11 between the control valve 14 and the temperature control unit 16 is specifically the portion of the refrigerant flow path 11 on the downstream side of the control valve 14 and the upstream side of the two-layer flow separator 15, which is the portion on the upstream side of the temperature control unit 16. The portion of the refrigerant flow path 11 on the downstream side of the temperature control unit 16 is specifically the portion of the refrigerant flow path 11 between the temperature control unit 16 and the gas-liquid separator 17 in this embodiment. By forming such an internal heat exchanger 19, the refrigerant flowing through the portion of the refrigerant flow path 11 between the control valve 14 and the temperature control unit 16 can be cooled. The refrigerant flowing through the portion of the refrigerant flow path 11 between the temperature control unit 16 and the gas-liquid separator 17 can be heated.

Further, the refrigerant flow device 10 includes a first temperature sensor 101, a second temperature sensor 102, a third temperature sensor 103, a first pressure sensor 104, a second pressure sensor 105, a first liquid level sensor 106, and a second liquid level sensor 107.

The first temperature sensor 101 detects the temperature of the refrigerant flowing through the temperature control unit 16. The second temperature sensor 102 detects the temperature of the refrigerant flowing through the portion of the refrigerant flow path 11 between the two-layer flow separator 15 and the temperature control unit 16. The third temperature sensor 103 detects the temperature of the refrigerant flowing through the portion of the refrigerant flow path 11 between the temperature control unit 16 and the gas-liquid separator 17 (portion upstream of the internal heat exchanger 19). The first pressure sensor 104 detects the pressure of the refrigerant flowing through the portion of the refrigerant flow path 11 between the two-layer flow separator 15 and the temperature control unit 16. The second pressure sensor 105 detects the pressure of the refrigerant flowing through the portion of the refrigerant flow path 11 between the temperature control unit 16 and the gas-liquid separator 17 (portion upstream of the internal heat exchanger 19).

The first liquid level sensor 106 detects the height of the refrigerant in the liquid phase stored in the reservoir tank 12. The second liquid level sensor 107 detects the height of the refrigerant in the liquid phase stored in the gas-liquid separator 17. The first liquid level sensor 106 and the second liquid level sensor 107 may include an optical sensor such as a laser displacement meter. In this case, the first liquid level sensor 106 and the second liquid level sensor 107 irradiates the liquid surface with light from above and receives reflected light, thereby calculating the height of the liquid surface. However, the first liquid level sensor 106 and the second liquid level sensor 107 may each include a float type sensor.

Each of the sensors (101 to 107) is electrically connected to the controller 30, and the detection result of each sensor is transmitted to the controller 30.

The pressure reducing device 20 includes a gas suction pump 22 that sucks a gas from the refrigerant flow path 11. The gas suction pump 22 sucks a gas from the refrigerant flow path 11 through the introduction port 20A connected to the downstream end 11D of the refrigerant flow path 11 and causes the gas sucked from the introduction port 20A to flow into the refrigerant flow path 11 through the outflow port 20B connected to the upstream end 11U of the refrigerant flow path 11. The introduction port 20A and the outflow port 20B may be formed in the gas suction pump 22 or may be formed in piping portions connected to the gas suction pump 22.

The type of gas suction pump 22 is not particularly limited, but is favorably a dry vacuum pump in which no or substantially no lubricating oil flows out to the suction path side. The dry vacuum pump may be a diaphragm type dry vacuum pump, a rocking piston type dry vacuum pump, a rotary vane type dry vacuum pump, a scroll type dry vacuum pump, or the like, or may be of a type different from the above examples. However, the gas suction pump 22 may be a wet vacuum pump.

The gas suction pump 22 in this embodiment is a dry vacuum pump. Then, the gas suction pump 22 includes a motor that is controlled by an inverter, such as an AC motor and a brushless DC motor. Then, the gas suction pump 22 is capable of adjusting the pressure inside the portion of the refrigerant flow path 11 downstream of the control valve 14 by adjusting the rotation speed of the motor to adjust the amount of gas to be sucked.

The gas suction pump 22 is electrically connected to the controller 30 and is controlled by the controller 30. In this embodiment, the gas suction pump 22 is electrically connected to the controller 30 via an inverter 40. The adjustment of the rotation speed of the above motor is specifically performed by adjusting the frequency of the AC current to be supplied to the motor by the controller 30 using the inverter 40.

The controller 30 is electrically connected to each of the above-mentioned sensors (101 to 107) and electrically connected to the control valve 14, the butterfly valve 18, and the gas suction pump 22. The controller 30 may include, for example, a computer including a CPU, a ROM, and the like. In this case, the controller 30 performs various types of processing in accordance with the program stored in the ROM. Note that the controller 30 may include another processor or an electrical circuit (e.g., FPGA (Field Programmable Gate Alley)).

### (Functional configuration of controller)

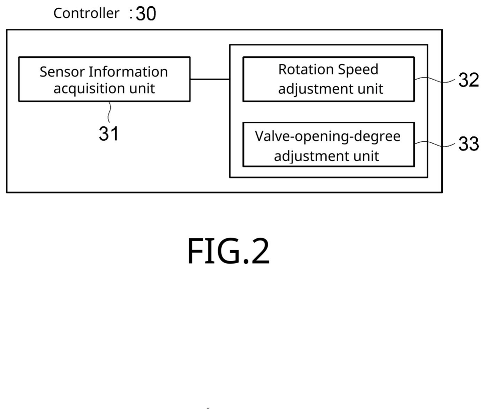

Fig. 2 is a block diagram showing a functional configuration of the controller 30. As shown in Fig. 2, the controller 30 includes a sensor information acquisition unit 31, a rotation speed adjustment unit 32, and a valve-opening-degree adjustment unit 33. Note that the controller 30 may include, for example, a single computer or a plurality of computers. In the case where the controller 30 includes a plurality of computers, the above plurality of functional units may be divided into the plurality of computers.

The sensor information acquisition unit 31 is a unit that acquires the detection result from each of the above-mentioned first temperature sensor 101, second temperature sensor 102, third temperature sensor 103, first pressure sensor 104, second pressure sensor 105, first liquid level sensor 106, and second liquid level sensor 107. The sensor information acquisition unit 31 provides one or a plurality of pieces of information regarding the acquired detection result to the rotation speed adjustment unit 32 and the valve-opening-degree adjustment unit 33.

The rotation speed adjustment unit 32 is a unit that is electrically connected to the gas suction pump 22 and controls the operation of the gas suction pump 22. In detail, the rotation speed adjustment unit 32 is connected to the motor in the gas suction pump 22 via the inverter 40. Then, the rotation speed adjustment unit 32 adjusts the flow rate of the gas to be sucked by the pressure reducing device 20 from the refrigerant flow path 11 by adjusting the frequency of the AC current to be supplied to the motor from the inverter 40.

A target temperature of the refrigerant at the temperature control unit 16 or the refrigerant before flowing into the temperature control unit 16 is input to the rotation speed adjustment unit 32 by, for example, an input device (not shown) and held. For example, the rotation speed adjustment unit 32 adjusts the rotation speed of the motor of the gas suction pump 22 such that the temperature detected by the first temperature sensor 101 or the second temperature sensor 102 matches the target temperature. That is, the gas suction pump 22 may be controlled in accordance with the difference between the temperature of the refrigerant that is the detection result from the first temperature sensor 101 or the second temperature sensor 102 and the target temperature.

Note that although the gas suction pump 22 of the pressure reducing device 20 is controlled such that the temperature of the refrigerant matches the target temperature in the control example described above, the rotation speed of the motor may be adjusted instead of this such that the pressure of the refrigerant in the refrigerant flow path 11 matches the target value.

The valve-opening-degree adjustment unit 33 is a unit that is electrically connected to the control valve 14 and the butterfly valve 18 and controls the operations of the control valve 14 and the butterfly valve 18. The valve-opening-degree adjustment unit 33 adjusts the flow rate of the refrigerant flowing through the refrigerant flow path 11 by adjusting the degree of opening of the control valve 14. Further, the valve-opening-degree adjustment unit 33 adjusts the amount of the gas sucked by the pressure reducing device 20 by adjusting the degree of opening of the butterfly valve 18.

A target temperature of the refrigerant at the temperature control unit 16 or the refrigerant before flowing into the temperature control unit 16 is input to the valve-opening-degree adjustment unit 33 by, for example, an input device (not shown) and held. For example, the degree of opening of the control valve 14 or the degree of opening of the butterfly valve 18 is adjusted such that the temperature detected by the first temperature sensor 101 or the second temperature sensor 102 matches the target temperature. Such control of the degree of opening of the control valve 14 or the butterfly valve 18 may be performed after the gas suction pump 22 is controlled such that the temperature of the refrigerant matches the target temperature and the operation state of the gas suction pump 22 is maintained constant.

### (Configuration of refrigerant)

Next, the refrigerant to be circulated in the cooling system S will be described. As described above, in this embodiment, the refrigerant is, for example, a substance that becomes liquid under the atmospheric pressure and at a standard environmental temperature (e.g., 25°C), which becomes -5°C or lower when expanded in an environment of, for example, 0.1 atm, desirably a substance that becomes -30°C or lower when expanded in an environment of 0.01 atm. Further, the refrigerant is desirably a refrigerant having a low environmental impact with a global warming potential (GWP) of 10 or less. In the case of a substance whose boiling point under the atmospheric pressure is 30°C or higher, the substance becomes liquid under the atmospheric pressure and at a standard environmental temperature (e.g., 25°C). Note that the boiling point of the refrigerant to be used under the atmospheric pressure may be 50°C or higher, 60°C or higher, or 70°C or higher.

Specifically, in this embodiment, HFO-1336mzz-Z, which has a GWP of2 and is non-flammable, is suitably used as a refrigerant. More specifically, the refrigerant may be Opteon SF33 (TM) manufactured by Chemours-Mitsui Fluoroproducts Co.,Ltd.

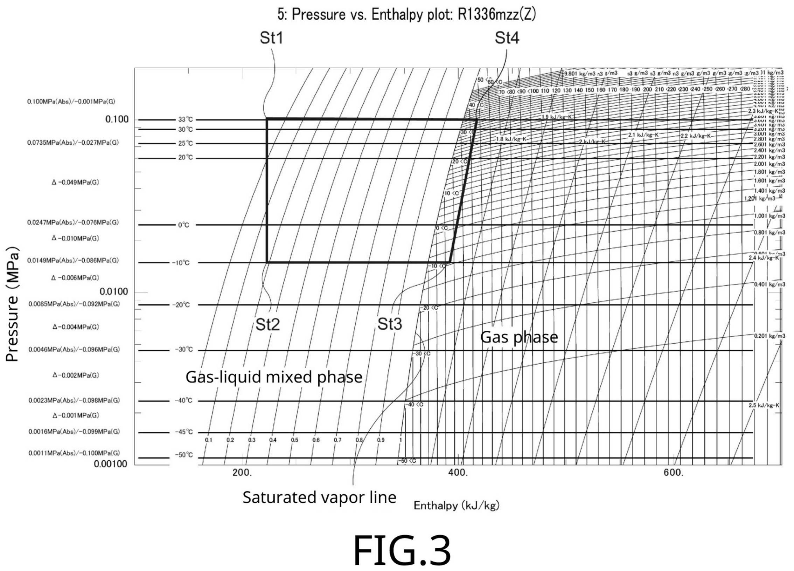

Fig. 3 is a pressure-enthalpy chart of HFO-1336mzz-Z. When the pressure of HFO-1336mzz-Z is reduced to 0.0149 MPa from the state (St1) in which the temperature is approximately 33°C close to room temperature at approximately 0.100 MPa close to the atmospheric pressure, the temperature of HFO-1336mzz-Z drops to approximately -10°C (St2). Further, when the pressure is reduced to 0.001 MPa, the temperature drops to approximately -50°C or lower. Then, it evaporates (St3) when absorbing heat to some extent from the state St2 in which the temperature has dropped to approximately -10°C. When it transitions to approximately 0.100 MPa close to the atmospheric pressure from this state St3, the temperature rises to approximately 50°C while being the gas phase, which is higher than room temperature (St4). Then, when being cooled at room temperature from the state St4, it is cooled to approximately 33°C while being condensed into a gas-liquid mixed phase.

Such HFO-1336mzz-Z is cooled by, for example, the cooler 12A in the reservoir tank 12 to transition to the above state St1, and then flows out from the control valve 14, whereby it is reduced in pressure and is capable of transitioning to, for example, the state St2. Then, HFO-1336mzz-Z is capable of transitioning from the state St2 to the state St3 by exchanging heat with the temperature control target in the temperature control unit 16. After that, it is capable of transitioning from the state St3 to the state St4 by flowing out from the gas-liquid separator 17 to the outside of the pressure reducing device 20. Therefore, HFO-1336mzz-Z can be suitably used in the cooling system S.

Various other refrigerants can be used in the cooling system S, and water and ethanol may be used for example.

### (Operation)

An example of the operation of the cooling system S will be described below.

First, in the cooling system S, a desired flow amount of refrigerant is stored from the reservoir tank 12 to the gas-liquid separator 17 in the refrigerant flow path 11. Then, for example, a target temperature of the refrigerant flowing through the temperature control unit 16 is input and held. Then, the pressure reducing device 20 is driven to reduce the pressure inside the portion of the refrigerant flow path 11 downstream of the control valve 14 to a pressure lower than the atmospheric pressure. At this time, the control valve 14 may be closed, or the degree of opening thereof may be narrowed. Then, in the pressure reducing device 20, the rotation speed of the motor of the gas suction pump 22 is adjusted until the temperature detected by the first temperature sensor 101 matches the target temperature.

After the temperature detected by the first temperature sensor 101 matches the target temperature, at least one of the rotation speed of the motor of the gas suction pump 22, the degree of opening of the control valve 14, or the degree of opening of the butterfly valve 18 is controlled to maintain the target temperature. In this way, the start-up operation is completed. After the rotation speed of the motor of the gas suction pump 22 is adjusted such that the temperature detected by the first temperature sensor 101 matches the target temperature, the pressure inside the portion of the refrigerant flow path 11 downstream of the control valve 14 is reduced to a pressure lower than the atmospheric pressure by the pressure reducing device 20, and the pressure in the portion of the refrigerant flow path 11 upstream of the control valve 14 is set to a pressure higher than the pressure inside the portion on the downstream side, e.g., the atmospheric pressure. However, the pressure in the portion of the refrigerant flow path 11 upstream of the control valve 14 does not necessarily need to be strictly the atmospheric pressure and may be a pressure slightly lower than the atmospheric pressure.

After that, a state of cooling the temperature control target by the temperature control unit 16 is transferred. After the refrigerant exchanges heat in the temperature control unit 16, the gas phase portion thereof is sucked by the pressure reducing device 20, flows into the refrigerant flow path 11 again from the upstream end 11U of the refrigerant flow path 11, is cooled until reaching the control valve 14, and then passes through the control valve 14 to flow into the temperature control unit 16 again. In this way, the temperature control target is continuously cooled by the refrigerant.

That is, when the operation state of the cooling system S is described with reference to Fig. 3, the refrigerant that has absorbs the heat of the temperature control target in the temperature control unit 16 flows into the upstream end 11U of the refrigerant flow path 11 from the downstream end 11D of the refrigerant flow path 11 via the pressure reducing device 20, and is cooled by the cooler 12A and the like before reaching the control valve 14, transitioning to the state St1 from the state St4 in Fig. 3. After that, the refrigerant is depressurized in the portion of the refrigerant flow path 11 downstream of the control valve 14 by flowing out from the control valve 14 and transitions to the state St2. Then, the refrigerant transitions to the state St3 from the state St2 by exchanging heat with the temperature control target in the temperature control unit 16. After that, the refrigerant transitions to the state St4 from the state St3 by flowing into the portion of the refrigerant flow path 11 on the upstream side of the control valve 14 from the pressure reducing device 20. Then, the refrigerant is cooled before reaching the control valve 14 and transitions to the state St1 from the state St4. In this way, the temperature control target is continuously cooled by the refrigerant.

The cooling system S according to the first embodiment described above includes the refrigerant flow device 10 that includes the refrigerant flow path 11 through which a refrigerant flows and the control valve 14 that is provided in the refrigerant flow path 11 and controls flow of the refrigerant, and the pressure reducing device 20 that includes the introduction port 20A and the outflow port 20B, the introduction port 20A being connected to the downstream end 11D of the refrigerant flow path 11 and sucking a gas from the refrigerant flow path 11, the outflow port 20B being connected to the upstream end 11U of the refrigerant flow path 11 and causing the gas sucked from the introduction port 20A to flow into the refrigerant flow path 11 from the upstream end 11U of the refrigerant flow path 11. The refrigerant flow path 11 allows the refrigerant included in the gas flowed in from the pressure reducing device 20 to flow. Then, the refrigerant flow device 10 includes the temperature control unit 16 that cools a temperature control target by the refrigerant, on the downstream side of the control valve 14 in the refrigerant flow path 11.

Such a cooling system S allows a substance that has not been used in the existing refrigeration system to be used as a refrigerant in a thermal cycle or the range of substances that can be used as a refrigerant in a thermal cycle to be expanded.

That is, as described above, in this embodiment, for example, a substance that becomes liquid under the atmospheric pressure and at a standard environmental temperature (e.g., 25°C), which becomes - 5°C or lower when expanded in an environment of, for example, 0.1 atm, can be used as a refrigerant. Meanwhile, if the above substance is used in a vapor compression type refrigeration cycle that has been widely used until now, for example, the compressor compresses the liquid, so that the compressor does not function properly and the substance does not evaporate in the evaporator. Therefore, the above refrigerant is not suitable for the vapor compression refrigeration cycle. Meanwhile, the cooling system S does not use compression and depressurizes the above refrigerant in the portion of the refrigerant flow path 11 downstream of the control valve 14, which allows the temperature control target to be cooled and the heat of the temperature control target to be released from the portion of the refrigerant flow path 11 on the upstream side of the control valve 14, thereby realizing a thermal cycle. Therefore, according to this embodiment, it is possible to allow a substance that has not been used in existing refrigeration methods to be used as a refrigerant in a thermal cycle or allow the range of substances that can be used as a refrigerant in a thermal cycle to be expanded.

Then, as described above, the cooling system S allows, for example, non-flammable HFO-1336mzz-Z having a GWP of 2, and the like to be used as a refrigerant. This allows a cooling operation that ensures a low GWP and safety, which has not been realized in the vapor compression refrigeration cycle, to be realized. Such a cooling system S that has a small environmental impact and ensures safety with a low GWP has not been known, including other cooling methods. Therefore, the realization of such a cooling system S has a possibility to make a significant contribution to protecting the global environment. Further, since no compressor is used in the cooling system S, lubricating oil is prevented from flowing out to the refrigerant side, which is also beneficial.

Further, the cooling system S includes, on the downstream side of the temperature control unit 16 in the refrigerant flow path 11, the gas-liquid separator 17 that separates a gas phase portion and a liquid phase portion such that the gas phase portion of the refrigerant that has passed through the temperature control unit 16 flows downstream of the liquid phase portion. With this configuration, the refrigerant in the liquid phase is prevented from being sucked by the pressure reducing device 20 from the downstream end 11D in the refrigerant flow path 11. This allows the pressure reducing device 20 to operate in a stable state and the stability of the operation of the cooling system S to be improved.

Further, the refrigerant flow device 10 includes, on the upstream side of the control valve 14 in the refrigerant flow path 11, the reservoir tank 12 that stores the refrigerant that has changed to a liquid phase from the gas flowed into the refrigerant flow path 11 from the pressure reducing device 20. Then, the control valve 14 controls the flow of the refrigerant in the liquid phase flowing in from the reservoir tank 12. With this configuration, the refrigerant in the gas phase whose temperature is relatively high in the refrigerant flowed into the refrigerant flow path 11 from the pressure reducing device 20 is prevented from flowing to the downstream side of the control valve 14 in the refrigerant flow path 11. This allows desired cooling to be achieved in the temperature control unit 16.

Further, the refrigerant flow device 10 includes the two-layer flow separator 15 between the control valve 14 and the temperature control unit 16 in the refrigerant flow path 11, and the two-layer flow separator 15 includes the inlet 15A and the outlet 15B, the inlet 15A causing the refrigerant from the control valve 14 to flow in, the outlet 15B being provided below the inlet 15A and causing the refrigerant flowed in from the inlet 15A to flow out. With this configuration, the high-temperature phase of the refrigerant flowed into the two-layer flow separator 15 is prevented from rapidly flowing out to the downstream side. This allows desired cooling to be achieved in the temperature control unit 16.

Further, in this embodiment, the portion of the refrigerant flow path 11 between the control valve 14 and the temperature control unit 16 and the portion of the refrigerant flow path 11 on the downstream side of the temperature control unit 16 constitute the internal heat exchanger 19 that allows the refrigerants flowing through the portions to exchange heat with each other. With this configuration, the refrigerant flowing through the portion of the refrigerant flow path 11 between the control valve 14 and the temperature control unit 16 can be cooled. The refrigerant flowing through the portion of the refrigerant flow path 11 between the temperature control unit 16 and the gas-liquid separator 17 can be heated. As a result, the refrigerant flowing into the temperature control unit 16 further cools down and the refrigerant flowing into the gas-liquid separator 17 is more likely to vaporize. For this reason, the cooling system S can be operated in a desirable state.

### <Application examples>

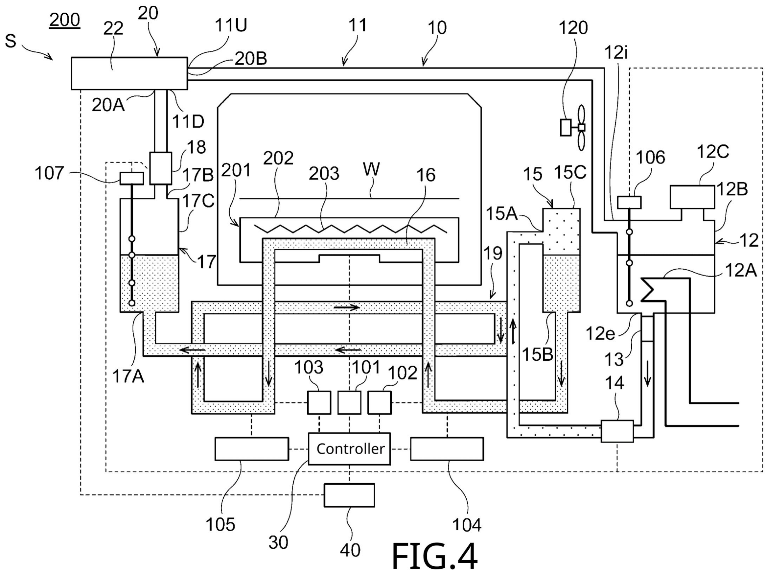

Application examples of the cooling system S according to the above-mentioned embodiment will be described below with reference to Fig. 4 to Fig. 7. The cooling system S in the application examples described below includes the same components as those in the above-mentioned embodiment unless otherwise specified.

### (Application example 1)

Fig. 4 is a schematic diagram of a plasma etching apparatus 200 including the cooling system S. The plasma etching apparatus 200 includes an electrostatic chuck 201. The electrostatic chuck 201 includes a plate-shaped base plate 202, and adsorbs and holds a wafer W on the surface of the base plate 202. Then, the base plate 202 and the temperature control unit 16 are connected such that the temperature control unit 16 of the cooling system S passes through the inside of the base plate 202. The temperature control unit 16 is capable of cooling the base plate 202 and the wafer W by absorbing heat from the base plate 202. In this example, the first temperature sensor 101 of the cooling system S is configured to detect the temperature of the base plate 202. Further, the base plate 202 also includes a built-in heater 203. The plasma etching apparatus 200 is capable of cooling and heating the wafer W. Further, in the cooling system S in Fig. 4, a fan 120 that cools the portion of the refrigerant flow path 11 on the upstream side of the reservoir tank 12 is provided. This promotes liquefication of the refrigerant flowed into the refrigerant flow path 11 from the pressure reducing device 20. Such a fan 120 can also be applied to the cooling system S according to the above-mentioned embodiment and the following application examples.

### (Application example 2)

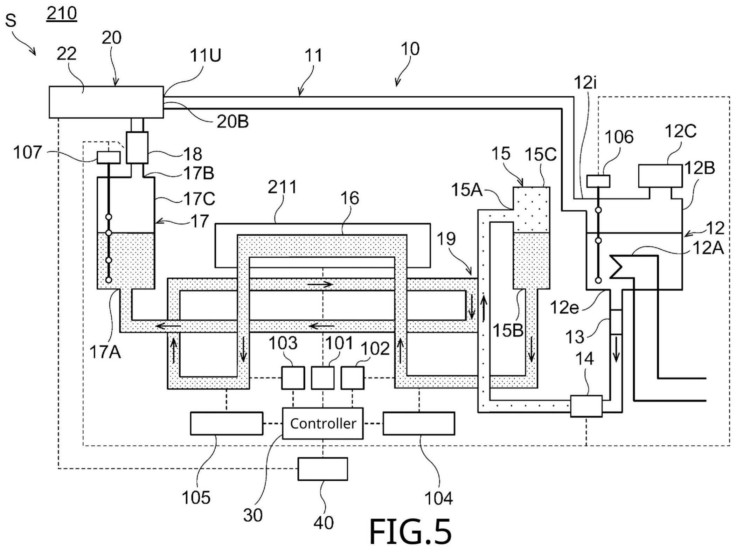

Fig. 5 is a schematic diagram of cooking equipment 210 including the cooling system S. The cooking equipment 210 is a so-called cold plate and includes a cooking plate 211 to be cooled by the temperature control unit 16 of the cooling system S. The temperature control unit 16 is connected to the cooking plate 211 while passing through the inside of the cooking plate 211. Further, in this example, the first temperature sensor 101 of the cooling system S is configured to detect the temperature of the cooking plate 211.

### (Application example 3)

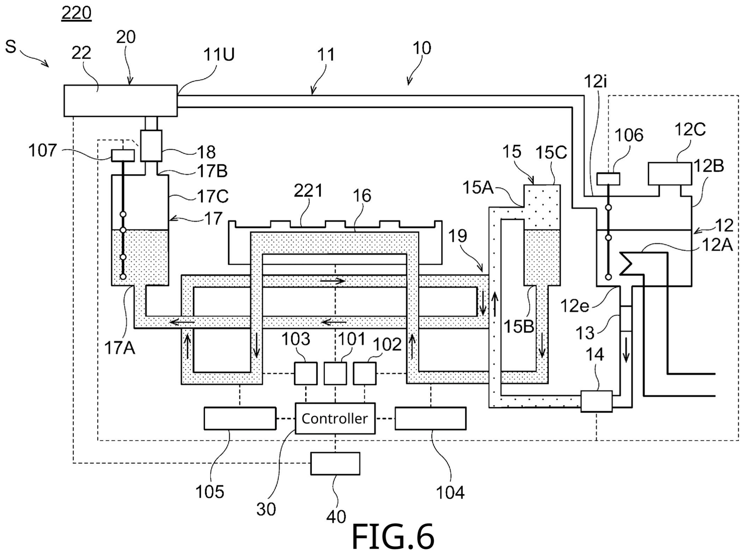

Fig. 6 is a schematic diagram of a molding apparatus 220 including the cooling system S. The molding apparatus 220 includes a mold 221 to be cooled by the temperature control unit 16 of the cooling system S. The temperature control unit 16 is connected to the mold 221 while passing through the inside of the mold 221. Further, in this example, the first temperature sensor 101 of the cooling system S is configured to detect the temperature of the mold 221.

### (Application example 4)

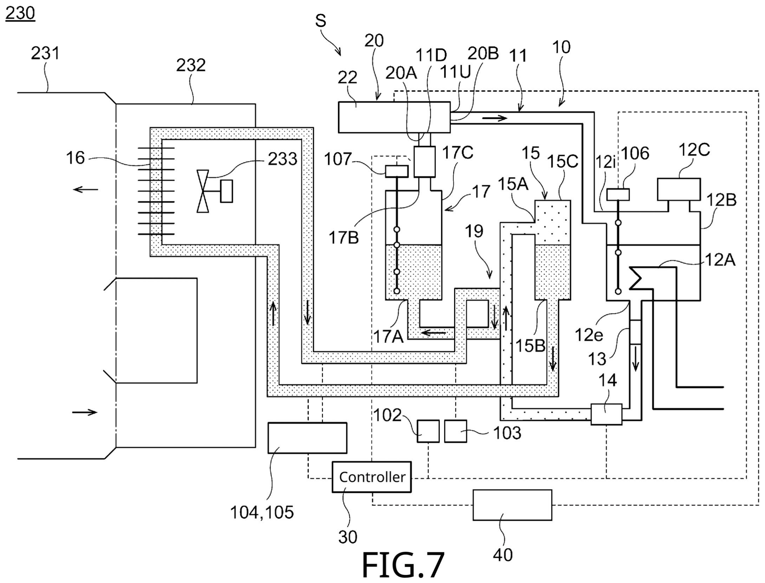

Fig. 7 is a schematic diagram of a freezer/refrigerator warehouse 230 including the cooling system S. The freezer/refrigerator warehouse 230 includes a warehouses body 231 and a duct 232 connected to the warehouses body 231. Both end portions of the duct 232 are connected to the warehouses body 231, one end portion sucks a gas from the warehouses body 231, and the sucked gas is caused to flow into the warehouses body 231 from the other end portion. A fan 233 is disposed in the duct 232, and the temperature control unit 16 of the cooling system S is also disposed therein. As the fan 233 rotates, a gas is sucked from the warehouses body 231 and this gas is cooled by the temperature control unit 16. As a result, the cooled gas flows into the warehouses body 231 from the duct 232. Note that although the first temperature sensor 101 that detects the temperature of the temperature control unit 16 is not provided in the example shown in Fig. 7, the first temperature sensor 101 may be provided.

Although an embodiment of the present invention has been described above, the present invention is not limited to the embodiment described above and various modifications can be made to the above-mentioned embodiment. Further, the cooling system S can be used for various purposes other than the application examples exemplified above.

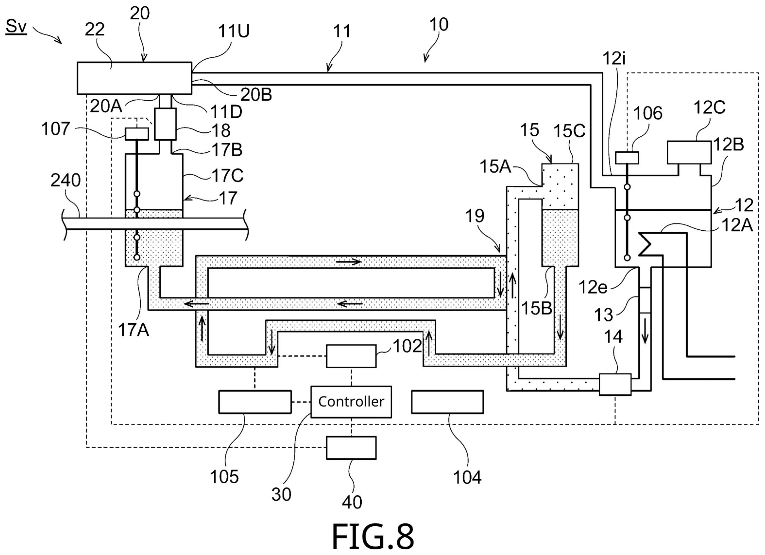

A cooling system Sv according to a modified example will be described below with reference to Fig. 8. In this cooling system Sv, the temperature control unit 16 and the gas-liquid separator 17 are integrated, and the temperature control unit 16 is not provided between the control valve 14 and the two-layer flow separator 15 unlike the above-mentioned embodiment. The gas-liquid separator 17 is configured to cool the temperature control target by the refrigerant in the liquid phase thereinside. In the example of Fig. 8, the temperature control target is a heating medium flowing through a heating medium piping member 240. The heating medium piping member 240 is connected to the gas-liquid separator 17 so as to pass through the inside of the gas-liquid separator 17.

Further, the cooling system Sv includes the dryer 13, the control valve 14, the two-layer flow separator 15, the temperature control unit 16, the gas-liquid separator 17, the butterfly valve 18, and the internal heat exchanger 19 similar to those in the above-mentioned embodiment. These components are similar to those in the above-mentioned embodiment. Further, the temperature control target is cooled by the refrigerant in the liquid phase inside the gas-liquid separator 17 in the cooling system Sv, but may be cooled by a refrigerant in a gas phase. Further, the cooling system Sv may be configured to perform cooling using the outer surface of the gas-liquid separator 17.

## Claims

1. A cooling system, comprising:
a refrigerant flow device that includes a refrigerant flow path through which a refrigerant flows and a control valve that is provided in the refrigerant flow path and controls flow of the refrigerant; and
a pressure reducing device that includes an introduction port and an outflow port, the introduction port being connected to a downstream end of the refrigerant flow path and sucking a gas from the refrigerant flow path, the outflow port being connected to an upstream end of the refrigerant flow path and causing the gas sucked from the introduction port to flow into the refrigerant flow path from the upstream end of the refrigerant flow path,
the refrigerant flow path allowing the refrigerant included in the gas flowed in from the pressure reducing device to flow,
the refrigerant flow device including a temperature control unit that cools a temperature control target by the refrigerant, on a downstream side of the control valve in the refrigerant flow path.

2. The cooling system according to claim 1, wherein
the refrigerant flow device includes, on a downstream side of temperature control unit in the refrigerant flow path, a gas-liquid separator that separates a gas phase portion and a liquid phase portion of the refrigerant that has passed through the temperature control unit such that the gas phase portion flows downstream of the liquid phase portion.

3. The cooling system according to claim 1, wherein
the refrigerant flow device includes, on an upstream side of the control valve in the refrigerant flow path, a reservoir tank that stores the refrigerant that has changed to a liquid phase from the gas flowed into the refrigerant flow path from the pressure reducing device, and
the control valve controls flow of the refrigerant in the liquid phase flowed in from the reservoir tank.

4. The cooling system according to claim 3, wherein
the reservoir tank includes a cooler that cools the gas flowed in from the pressure reducing device and liquefies the refrigerant from the gas.

5. The cooling system according to claim 1, wherein
the refrigerant flow device includes a two-layer flow separator between the control valve and the temperature control unit in the refrigerant flow path, and
the two-layer flow separator includes an inlet that causes the refrigerant from the control valve to flow in and an outlet that is provided below the inlet and causes the refrigerant flowed in from the inlet to flow out.

6. The cooling system according to claim 1, wherein
a portion of the refrigerant flow path between the control valve and the temperature control unit and a portion of the refrigerant flow path on a downstream side of the temperature control unit constitute an internal heat exchanger that allows the refrigerants flowing through the portions to exchange heat with each other.

7. The cooling system according to claim 1, wherein
the cooling system is configured to form a state in which a pressure inside a portion of the refrigerant flow path on a downstream side of the control valve is lower than a pressure inside a portion of the refrigerant flow path on an upstream side of the control valve by an operation of the pressure reducing device and a throttle state of the control valve cause.

8. The cooling system according to claim 1, wherein
the refrigerant is a substance whose boiling point is 30°C or more under an atmospheric pressure.

9. The cooling system according to claim 8, wherein
the refrigerant has a GWP of 10 or less.

10. The cooling system according to claim 9, wherein
the refrigerant is HFO-1336mzz-Z.
